# EUROPEAN PATENT APPLICATION

(11) **EP 4 742 297 A1**
(43) Date of publication of application: **13.05.2026**
(21) Application number: 25180252.6
(22) Date of filing: 02.06.2025
(51) Int. Cl.: H01J 37/32

(54) **METHOD OF PLASMA ETCHING**

(30) Priority: 07.11.2024 GB 202416394
(71) Applicant: SPTS Technologies Limited, Newport Gwent NP18 2TA (GB)
(72) Inventor: Kazemi, Samira Binte, Pontuclun, CF72 4AH (GB)
(74) Representative: Wynne-Jones IP Limited

(57) **Abstract**

There is provided a method of inductively coupled plasma etching an additive-containing aluminium nitride film, wherein the additive is selected from scandium, yttrium and erbium. The method comprises placing a workpiece upon a platen assembly within a plasma etch chamber, the workpiece comprising a substrate having the additive-containing aluminium nitride film deposited thereon and a photoresist mask disposed upon the film. The method further comprises powering the plasma etch chamber with an RF power supply, applying a bias power to the platen assembly, and bulk etching the additive-containing aluminium nitride film through the photoresist mask using a switched process by repeatedly alternating between the steps of (i) plasma etching the film by feeding a chlorinated etching gas and an inert diluent gas to the plasma etch chamber at substantially equal flow rates at a target chamber pressure, and (ii) plasma etching the film using the same chlorinated etching gas and inert diluent gas, at the same target chamber pressure, wherein the flow rate of the inert diluent gas is at least four times the flow rate of the chlorinated etching gas.

## Description

### Field

This invention relates to a method of plasma etching, with particular reference to a method of plasma etching an additive-containing aluminium nitride film. The invention relates also to an apparatus for plasma etching an additive-containing aluminium nitride film.

### Background

Aluminium Scandium Nitride (AlSCN) is a piezoelectric material used in a range of applications including Bulk Acoustic Wave (BAW) filters for communications (e.g. 5G), microphones, and sensors. Improving the piezoelectric performance for devices (in particular thinner devices) is a major challenge as tolerances become tighter and the integration of the devices on circuit boards becomes more complicated.

A key step in the fabrication of devices is etching a layer of aluminium scandium nitride to stop on a molybdenum bottom electrode, whilst minimising electrode loss. Generally, a two-step etch process is used if landing onto a molybdenum electrode. A bulk etch which is optimised for aluminium scandium nitride etch rate and selectivity to the resist mask is followed by a soft-landing etch step with high selectivity to molybdenum but lower aluminium scandium nitride etch rate. Typically, the bulk etch will remove 85-90% of the aluminium scandium nitride film. By switching to the soft-landing process less molybdenum is lost during the over etch. Etching is typically undertaken though a mask, which defines etch regions (i.e. trenches). Ideally the etch will produce steep sidewalls in the aluminium scandium nitride layer without any redeposition, and with minimal footing or micro-trenching. Footing occurs when there is a difference between the etch rates close to the mask and further from the mask and requires additional etch time to eliminate, leading to unwanted molybdenum loss. The causes of foot formation are thought to be ion glancing from the mask sidewalls and/or delay in sputtering of etch byproducts from the sidewalls. Micro-trenching is caused by reflection of ions from the trench sidewalls which results in a local increase in etch rate at the bottom of the trench adjacent the sidewalls. Micro-trenching results in an uneven etch of the aluminium scandium nitride layer and can also result in unwanted molybdenum loss.

Whilst the main etch can be controlled to provide steep sidewalls which are redeposition free and avoid footing, the soft landing etch nevertheless leads to a footing. The footing (i.e. caused by an etch depth lag between close to mask and far from mask regions) tends to be more pronounced with increased scandium content and thickness of the aluminium scandium nitride layer.

There is a need in the art for an improved method of etching aluminium scandium nitride film which minimises underlying electrode loss and eliminates footing, particularly when using a photoresist mask. To ensure device performance it is necessary to eliminate the footing, but this has proven difficult to achieve without an additional etch, which is undesirable as it tends to result in increased bottom electrode loss.

### Summary

In a first aspect of the invention there is provided a method of inductively coupled plasma etching an additive-containing aluminium nitride film, wherein the additive is selected from scandium, yttrium and erbium. The method comprises placing a workpiece upon a platen assembly within a plasma etch chamber, the workpiece comprising a substrate having the aluminium nitride film deposited thereon and a photoresist mask disposed upon the film, powering the plasma etch chamber with an RF power supply, applying a bias power to the platen assembly, and bulk etching the additive-containing aluminium nitride film through the photoresist mask using a switched process by repeatedly alternating between the following steps: (i) plasma etching the film by feeding a chlorinated etching gas and an inert diluent gas to the plasma etch chamber at substantially equal flow rates at a target chamber pressure; and (ii) plasma etching the film using the same chlorinated etching gas and inert diluent gas, at the same target chamber pressure, wherein the flow rate of the inert diluent gas is at least four times the flow rate of the chlorinated etching gas.

Optionally, the method includes increasing the bias power to the platen assembly during step (i). Advantageously, this avoids redeposition build up on the sides of the etched feature.

Optionally, alternating between steps (i) and (ii) occurs every 2-6 seconds.

Optionally, the substrate comprises a silicon wafer supporting a molybdenum electrode layer between the wafer and the additive-containing aluminium nitride film.

Optionally, the chlorinated gas comprises chlorine.

Optionally, the inert diluent gas comprises argon.

Optionally, the plasma etch chamber is powered with an RF power in the range 600-1200 W.

Optionally, a bias power of 800-1400 W is applied to the platen assembly.

Optionally, the bias power is increased by 200-500 W during step (i).

Optionally, during the bulk etching of the additive-containing aluminium nitride film, the plasma etch chamber is maintained at a pressure in the range 2-5 mTorr.

Optionally, the method includes during step (i), introducing each of the chlorinated etching gas and inert diluent gas into the plasma etch chamber at a flow rate of approximately 30-70 sccm.

Optionally, the method includes during step (ii), introducing the chlorinated etching gas into the plasma etch chamber at a flow rate of approximately 60-120 sccm and the inert diluent gas into the plasma etch chamber at a flow rate of approximately 5-25 sccm.

Optionally, the method includes after the bulk etch, plasma etching the remaining additive-containing aluminium nitride film in a soft landing step by using a chlorinated etching gas comprising boron trichloride and chlorine in a 1:1 ratio and an inert diluent gas comprising argon, wherein the bulk etch produces a microtrench which is removed by the soft landing step.

Optionally, the photoresist mask profile is less than 75 degrees.

Optionally, the additive-containing aluminium nitride film contains scandium, and is defined by the formula AlxScyN, where x + y = 1; and wherein the scandium content y is 0.25 or more, optionally about 0.4 (representing 25-40% or more scandium in the films).

Optionally, the aluminium nitride film has a depth and bulk etching the additive-containing aluminium nitride film comprises bulk etching at least 85% of the depth.

In a second aspect of the invention there is provided an inductively coupled plasma apparatus for plasma etching an additive-containing aluminium nitride film, the additive being selected from scandium, yttrium and erbium, the apparatus comprising: an ICP plasma etch chamber; a platen assembly disposed within the plasma etch chamber configured to receive a workpiece comprising a substrate having the aluminium nitride film deposited thereon and a photoresist mask disposed upon the film; a gas delivery system for feeding a chlorinated etching gas and an inert diluent gas into the plasma etch chamber; a plasma generation device for sustaining a plasma within the plasma etch chamber for etching the aluminium nitride film of the workpiece; and a controller configured to control the apparatus to perform a bulk plasma etch of the aluminium nitride film through the photoresist mask in a switched process by repeatedly alternating between a first step in which the chlorinated etching gas and the inert diluent gas are fed into the plasma etch chamber in substantially equal amounts and a second step in which at least twice as much of the inert diluent gas is fed into the plasma etch chamber compared to the chlorinated etching gas.

### Drawings

An example embodiment of the invention will now be described by way of example only with reference to the following figures:
Figure 1 shows an apparatus for plasma etching an aluminium scandium nitride film;
Figure 2 shows a workpiece comprising an aluminium scandium nitride film prior to etching;
Figure 3 shows the workpiece of Figure 2 which has been etched to produce a footing;
Figure 4 shows the workpiece of Figure 2 which has been etched to produce a micro-trench;
Figure 5 shows the workpiece of Figure 2 which has been etched without any footing or micro-trench; and
Figure 6 shows a flow diagram of a method of etching an aluminium scandium nitride film.

### Specific Description

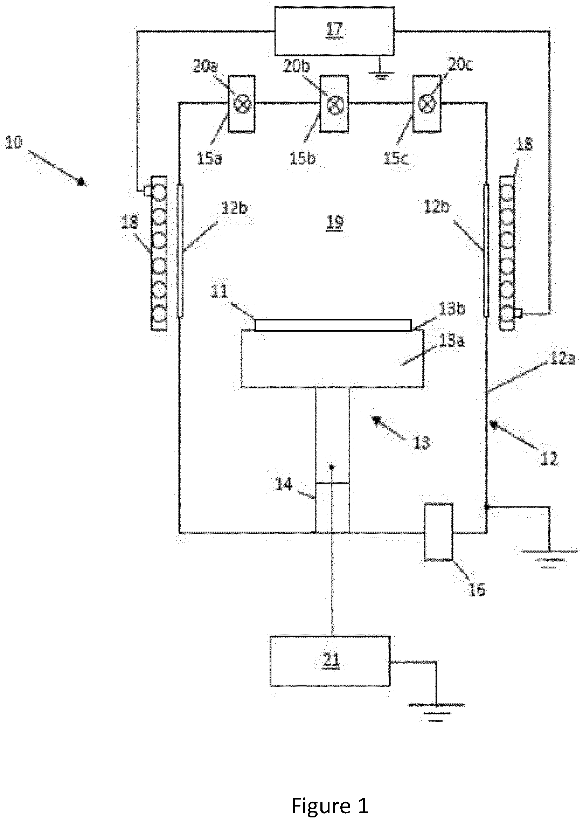

Referring to Figure 1 of the drawings, there is provided a schematic illustration of an apparatus 10 for plasma etching a workpiece 11. The apparatus 10 is an inductively coupled plasma (ICP) etch apparatus comprising a plasma etch chamber 12, within which the plasma etching of the workpiece 11 is performed.

The apparatus 10 further comprises a substrate support 13. The substrate support can be a platen assembly 13, which may also be formed of a metal, such as aluminium, disposed within the chamber 12, but which is electrically isolated from the chamber walls 12a by conventional means, such as ceramic breaks 14.

The substrate support can also comprise an electrostatic chuck (ESC), which can be attached to the surface of the platen assembly. The platen assembly 13 comprises a body 13a having a support surface 13b for receiving the workpiece 11 and is electrically biased using a radio frequency (RF) voltage generator. The provision of a negative bias voltage to the platen assembly 13 for example, can help to control positively charged ion bombardment of the surface of the workpiece 11 from the plasma.

The plasma etch chamber 12 comprises chamber walls 12a which may be formed of a metal, such as aluminium for example, and which are typically electrically grounded. The chamber 12 further comprises a first, a second and a third gas inlet 15a, 15b, 15c via which a source of chlorine (CI) gas, boron trichloride (BCl₃) gas and an inert diluent gas such as argon respectively, can fluidly couple for introducing the gases into the chamber 12. Some or all of the gases may be used at different stages of the process. The chamber 12 further comprises an outlet 16, via which the gases and any by-products of the etching process can pass out from the chamber 12.

In an embodiment, the plasma is an ICP plasma generated by applying an RF voltage from an RF voltage generator 17, to one or more antenna 18, which are disposed around the chamber 12 and located adjacent a respective dielectric window section 12b formed in the chamber walls 12a. The one or more antenna 18 may comprise a substantially planar spiral configuration, a helical coil configuration or a toroidal configuration, for example, and as with standard practice, impedance matching of the RF signal from the generator 17 with the antenna 18 is carried out to minimize reflection of electrical power from the antenna 18. The antennas 18 are placed around the chamber 12 and the electrical power is inductively coupled into the chamber 12, through the dielectric window sections 12b.

A plasma is generated in a region 19 of the chamber 12 which is disposed above the workpiece 11 so that the workpiece 11 becomes exposed to the plasma. Some or all of the process gases are introduced into the chamber 12 via a respective flow regulator 20a, 20b, 20c coupled with the respective inlet 15a, 15b, 15c, and the inlet 15a, 15b, 15c and outlet 16 of the chamber 12 are disposed on opposite sides of the plasma region 19 so that the etching gases are required to pass through the chamber 12, via the region 19 and over the workpiece 11, in passing to the outlet 16.

An alternative apparatus which can be used to perform the invention is a Synapse (RTM) module produced by the applicant, SPTS Technologies Limited (Newport, UK).

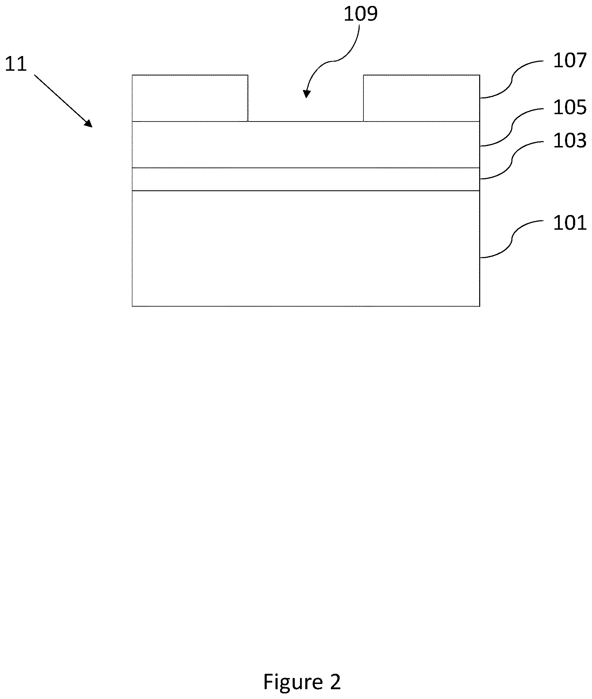

In the example embodiment, the workpiece 11 (referring to Figure 2) comprises a 200 mm silicon wafer 101 supporting a 200nm thick molybdenum electrode layer 103, with a 1000 nm thick aluminium scandium nitride film 105 deposited on top. In the example embodiment, the molybdenum and aluminium scandium nitride films were deposited in a Sigma *fxP* physical vapour deposition (PVD) tool. The workpiece is patterned with a photoresist mask 107 defining etch trenches 109. In the example embodiment the photoresist mask defines a ~15% open area (but in other examples can define a smaller or larger open area). The mask is adjusted to achieve <75° mask profile (i.e. a shallow angle) to prevent etch by-product build-up on the sidewall of the etched feature by known means. In other examples, the workpiece may comprise a different size of wafer, a substrate other than silicon, an electrode other than molybdenum or have different depths of layers or comprise additional layers. In the example embodiment the scandium content of the aluminium scandium nitride layer is ~35%, however it will be appreciated that the principles of the invention apply equally to other content levels, for example between 25%-45% scandium content.

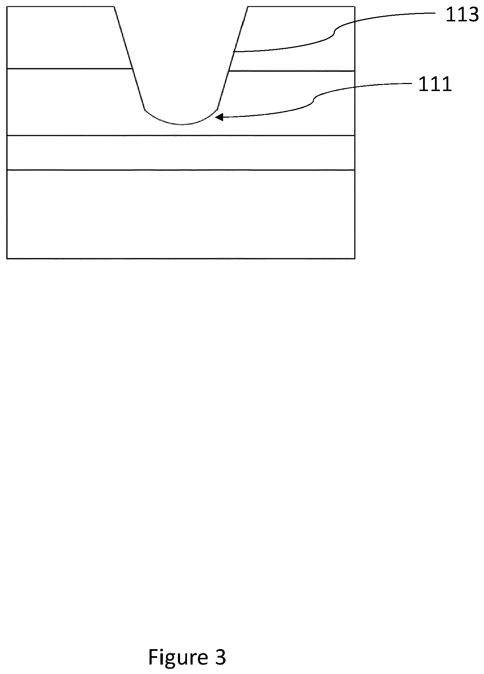

The effect of footing in such a workpiece is shown in Figure 3. In certain etch methods of the prior art, footing occurs due to a difference in the etch rate near and far from the mask which results in a build-up 111 adjacent the side walls 113 of the trench.

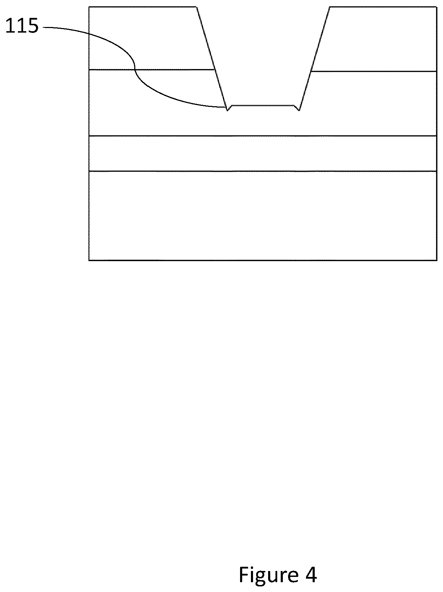

The effect of micro-trenching in such a workpiece is shown in Figure 4. In certain etch methods of the prior art, ion reflection from the trench sidewalls at the bottom of the trench causes a micro-trench 115 to form adjacent the sidewalls. The present invention aims to eliminate the effects of footing and micro-trenching during etching of the aluminium scandium nitride film.

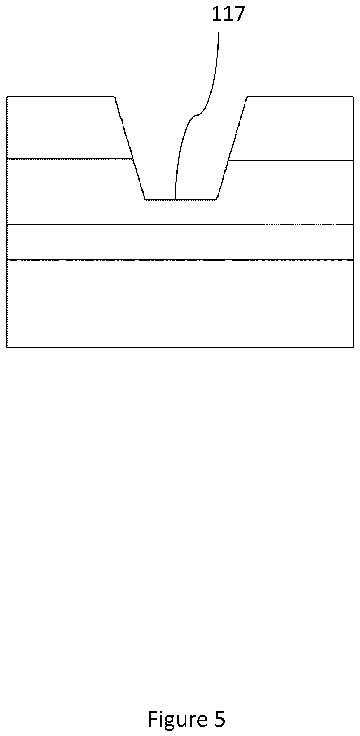

Methods in accordance with the invention etch a flat-bottomed trench as shown in Figure 5, without any footing or micro-trenching.

Methods in accordance with the invention will be demonstrated with reference to an aluminium scandium nitride film, but the skilled reader will recognize that the methods are equally applicable to aluminium yttrium nitride (AlYN) films and aluminium erbium nitride (AlErN) films.

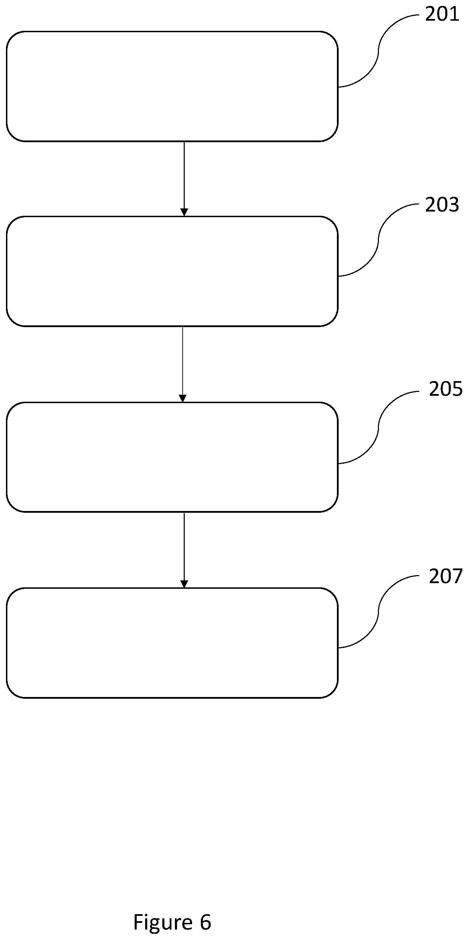

A method of plasma etching the aluminium scandium nitride film 105 according to the example embodiment (Figure 6) comprises: placing 201 the workpiece 11 upon the platen assembly 13 within the plasma etch chamber 12. The method further comprises powering 203 the plasma etch chamber with an RF power supply to generate a plasma from gases fed to the plasma etch chamber. The method further comprises applying 205 a bias power to the platen assembly. The method further comprises bulk etching 207 the aluminium scandium nitride film through the photoresist mask using a switched process by repeatedly alternating between the steps of plasma etching the film by feeding a chlorinated etching gas and an inert diluent gas to the plasma etch chamber in substantially equal amounts, and plasma etching the film using the same chlorinated etching gas and inert diluent gas by feeding at least twice as much of the inert diluent gas to the plasma etch chamber compared to the chlorinated etching gas.

In the example embodiment of the invention, the plasma etch chamber is powered at ~1000 W during the first step of the etch, and at 800-1000 W during the second step of the etch. Switching between each step of the etch occurs every 3-5 seconds. The process continues for ~70 loops (wherein each loop comprises undertaking each step of the etch once), the number of loops being determined by the depth of the aluminium scandium nitride layer. During the process, the plasma etch chamber is maintained at a pressure of 2-5 mTorr. In the example embodiment the chlorinated etching gas comprises chlorine, and the inert diluent gas comprises argon (although it will be appreciated that other chlorinated etching gases and inert diluent gases would be suitable). Typical etch rates are 85-142 nm/min.

The respective amounts of the etching and diluent gases entering the chamber can be controlled by varying the gas flow rates into the plasma etch chamber. In the first step of the etch, argon gas is fed to the plasma etch chamber at a gas flow rate of approximately 45-50 sccm. At the same time chlorine gas is fed to the plasma etch chamber at a gas flow rate of approximately 45-50 sccm. In other words, the etching and diluent gas flow rates are substantially the same thus providing approximately equal amounts of the gases to the plasma etch chamber in the first step of the etch. It will be appreciated however, that the gas pressures and flow rates could be varied but still supply approximately equal amounts of the gases to the plasma etch chamber. Either the flow rate or pressure can be changed to change the amount of gas being delivered. The platen power (i.e. the bias power applied to the platen assembly 13) in the first step of the etch is in the range 1000-1350 W. In practice, a pressure of 2-5 mTorr is targeted, and then flow rates are established in the desired ranges using the flow regulators.

In the second step of the etch, argon gas is fed to the plasma etch chamber at a gas flow rate of approximately 85-95 sccm. At the same time chlorine gas is fed to the plasma etch chamber at a gas flow rate of approximately 5-15 sccm. The plasma etch chamber is maintained at a pressure of 2-5 mTorr. In other words, the diluent gas flow rate is at least double, for example more than four times the etching gas flow rate, thus providing to the plasma etch chamber at least twice as much of the diluent gas compared to the etching gas in the second step of the etch. It will be appreciated however, that the flow rates may be different if the gas pressures are varied, without changing the overall effect of providing more of the diluent gas to the plasma etch chamber. The platen power (i.e. the bias power applied to the platen assembly 13) in the second step of the etch is in the range 1000-1200 W. The second step of the etch may be referred to as a "sputter step". Since the diluent has a high sputter mass, the cyclical etch process with fast switching results in increased sputtering of etch by-product in the form of ScCl₃ from the trench sidewalls compared to methods of the prior art. The etch depth lag between close to mask and far from mask regions is reduced leading to reduced foot formation. A low process pressure ensures uniformity and assists the sputtering. High bias power applied to the platen assembly and moderate source power further assist the sputtering.

In the example embodiment in the bulk etch, approximately 85% of the aluminium scandium nitride film is etched. The remaining aluminium scandium nitride can be etched in a soft landing step.

Ultimately after all of the AlScN is etched, with minimal loss of molybdenum, there should be no footing. By minimising footing in the bulk etch or being able to produce a controlled depth of micro-trenching, as seen in Figure 4, it is possible to further optimise the soft landing step. Typical soft-landing processes with high selectivity to molybdenum ~4:1 exhibit slight footing. By tuning the bulk etch process to produce a small amount of micro-trenching with a soft landing step which would normally produce some footing it is possible to eliminate footing and achieve minimal electrode loss. Typically a soft landing process use BCl₃/Cl₂ or and Ar or BCl₂/Ar at ~2-5mTorr and an exemplary process is described in GB2412922.3.

## Claims

1. A method of inductively coupled plasma etching an additive-containing aluminium nitride film, wherein the additive is selected from scandium, yttrium and erbium, the method comprising:
placing a workpiece upon a platen assembly within a plasma etch chamber, the workpiece comprising a substrate having the additive-containing aluminium nitride film deposited thereon and a photoresist mask disposed upon the film;
powering the plasma etch chamber with an RF power supply;
applying a bias power to the platen assembly; and
bulk etching the additive-containing aluminium nitride film through the photoresist mask using a switched process by repeatedly alternating between the following steps:
(i) plasma etching the film by feeding a chlorinated etching gas and an inert diluent gas to the plasma etch chamber at substantially equal flow rates at a target chamber pressure; and
(ii) plasma etching the film using the same chlorinated etching gas and inert diluent gas, at the same target chamber pressure, wherein the flow rate of the inert diluent gas is at least four times the flow rate of the chlorinated etching gas.

2. A method according to claim 1, including increasing the bias power to the platen assembly during step (i).

3. A method according to claim 1 or 2, wherein alternating between steps (i) and (ii) occurs every 2-6 seconds.

4. A method according to any preceding claim, wherein the substrate comprises a silicon wafer supporting a molybdenum electrode layer between the wafer and the additive-containing aluminium nitride film.

5. A method according to any preceding claim, wherein the chlorinated gas comprises chlorine; and/or, wherein the inert diluent gas comprises argon.

6. A method according to any preceding claim, wherein the plasma etch chamber is powered with an RF power in the range 600-1200 W; and/or wherein a bias power of 800-1400 W is applied to the platen assembly.

7. A method according to any preceding claim, wherein the bias power is increased by 200-500 W during step (i).

8. A method according to any preceding claim, wherein during the bulk etching of the additive-containing aluminium nitride film, the plasma etch chamber is maintained at a pressure in the range 2-5 mTorr.

9. A method according to any preceding claim, including during step (i), introducing each of the chlorinated etching gas and inert diluent gas into the plasma etch chamber at a flow rate of approximately 30-70 sccm.

10. A method according to any preceding claim, including during step (ii), introducing the chlorinated etching gas into the plasma etch chamber at a flow rate of approximately 60-120 sccm and the inert diluent gas into the plasma etch chamber at a flow rate of approximately 5-25 sccm.

11. A method according to any preceding claim, further including after the bulk etch, plasma etching the remaining additive-containing aluminium nitride film in a soft landing step by using a chlorinated etching gas comprising boron trichloride and chlorine in a 1:1 ratio and an inert diluent gas comprising argon, wherein the bulk etch produces a microtrench which is removed by the soft landing step.

12. A method according to any preceding claim, wherein the photoresist mask profile is less than 75 degrees.

13. A method according to any preceding claim, wherein the additive-containing aluminium nitride film contains scandium, and is defined by the formula AlxScyN, where x + y = 1; and wherein the scandium content y is 0.25 or more, optionally about 0.4.

14. A method according to any preceding claim, wherein the additive-containing aluminium nitride film has a depth and bulk etching the additive-containing aluminium nitride film comprises bulk etching at least 85% of the depth.

15. An inductively coupled plasma apparatus for plasma etching an additive-containing aluminium nitride film, the additive being selected from scandium, yttrium and erbium, the apparatus comprising:
an ICP plasma etch chamber;
a platen assembly disposed within the plasma etch chamber configured to receive a workpiece comprising a substrate having the additive-containing aluminium nitride film deposited thereon and a photoresist mask disposed upon the film;
a gas delivery system for feeding a chlorinated etching gas and an inert diluent gas into the plasma etch chamber;
a plasma generation device for sustaining a plasma within the plasma etch chamber for etching the additive-containing aluminium nitride film of the workpiece; and
a controller configured to control the apparatus to perform a bulk plasma etch of the additive-containing aluminium nitride film through the photoresist mask in a switched process by repeatedly alternating between a first step in which the chlorinated etching gas and the inert diluent gas are fed into the plasma etch chamber in substantially equal amounts and a second step in which at least twice as much of the inert diluent gas is fed into the plasma etch chamber compared to the chlorinated etching gas.
